# EUROPEAN PATENT SPECIFICATION

(11) **EP 2 546 893 B1**
(45) Date of publication and mention of the grant of the patent: **31.07.2019**
(21) Application number: 12156434.8
(22) Date of filing: 22.02.2012
(51) Int. Cl.: H01L 33/22, H01L 33/44, H01L 33/42, H01L 33/40

(54) **Light emitting device with a roughened surface and including an etching control layer for photoelectrochemical etching, light emitting device package, and light unit**
Lichtemittierende Vorrichtung mit einer aufgerauten Oberfäche und einer Ätzkontrollschicht für photoelektrochemisches Ätzen, Gehause für eine lichtemittierende Vorrichtung und eine Beleuchtungseinheit
Dispositif électroluminescent avec une surface rendue rugueuse et comportant une couche de contrôle de gravure photoélectrochimique, boîtier de dispositif électroluminescent et unité d'éclairage

(30) Priority: 14.07.2011 KR 20110069824
(43) Date of publication of application: 16.01.2013
(73) Proprietor: LG Innotek Co., Ltd., Seoul, 04637 (KR)
(72) Inventor: Kang, Dae Sung, 100-714 Seoul (KR); Choi, Rak Jun, 100-714 Seoul (KR); Jung, Sung Hoon, 100-714 Seoul (KR); Han, Young Hun, 100-714 Seoul (KR); Son, Sung Jin, 100-714 Seoul (KR)
(74) Representative: Zardi, Marco

(56) References cited:
- EP-A1- 2 312 655
- EP-A2- 2 262 014
- DE-A1-102008 030 584
- JP-A- 2005 136 002
- KR-A- 20090 018 451
- KR-A- 20110 031 943
- US-A1- 2006 281 284
- US-A1- 2008 135 856

## Description

### BACKGROUND

An embodiment of the present invention relates to a light emitting device, and method of fabricating light emitting device, a light emitting device package, and light unit.

An example of a light emitting device has used generally a light emitting diode. The light emitting diode converts an electrical signal into a light type such as an infrared light, a visible light and an ultraviolet light using a feature of a compound semiconductor.

The light emitting device has been used in various fields such as a display device and a lighting device as a lighting efficiency of the light emitting device increases.

A scheme for improving light extraction efficiency of the light emitting device has been proposed to form a roughness on an upper surface of a light emitting structure. Among the scheme for forming the roughness on the upper surface of the light emitting structure, a photo electrochemical etching scheme (PEC) has been used. However, an over etching occurs even to an active layer containing the light emitting structure in performing the etching for the light emitting structure using PEC etching scheme. Therefore, there have been studied the scheme for preventing the active layer to be damaged due to the etching of the active layer even in using the PEC etching scheme.

A further example of a light emitting device according to the prior art is known from documents US 2008/135856 A1, KR 2009 0018451 A and KR 2011 0031943 A.

### SUMMARY OF THE INVENTION

The present invention is to provide a light emitting device, and method of fabricating light emitting device, a light emitting device package, and light unit for forming roughness on a light emitting structure using a PEC etching scheme and preventing a active layer composed of a light emitting structure to be damaged.

A light emitting device according to an embodiment of the present invention may-comprises a first conductive semiconductor layer providing a roughness on a upper surface thereof and containing a PEC etching control layer; an active layer under the first conductive semiconductor layer; a second conductive semiconductor layer under the active layer; a reflective electrode electrically connected to the second conductive semiconductor layer; and a first electrode electrically connected to the first conductive semiconductor layer along with the further features as recited in claim 1.

A method of fabricating light emitting device according to another embodiment of the present invention may-comprises forming a first conductive semiconductor layer composed of PEC etching control layer on a substrate; forming a active layer on the first conductive semiconductor layer; forming a second conductive semiconductor layer on the active layer; forming a reflective electrode on the second conductive semiconductor layer; forming a support member on the reflective electrode; removing the substrate; performing an a PEC etching on the exposed first conductive semiconductor layer to form a roughness on a upper surface of the first conductive semiconductor layer along with the further features as recited in claim 3.

A lisht emitting device package according to an embodiment of the present invention as claimed in claim 4 comprises a body; a light emitting device with the features of one of claims 1 or 2 disposed on the body; a first and second lead electrode electrically connected to the light emitting device.

A light unit according to an embodiment of the present invention as claimed in claim 5 comprises a board; an light emitting device according to one of claims 1 or 2 disposed on the board; and an optical member passing light provided from the light emitting device.

According to an embodiment of the present invention, an ohmic contact layer is disposed between the reflective electrode and the second conductivity type semiconductor layer.

### BRIEF DESCRIPTION OF THE DRAWINGS

FIG. 1 is a view showing a light emitting device according to an embodiment of the present invention.
FIGS. 2 to 7 are a view showing a method of fabricating light emitting device according to an embodiment of the present invention.
FIG. 8 is a view showing a light emitting device package according to an embodiment of the present invention.
FIG. 9 is a view showing a display device according to an embodiment of the present invention.
FIG. 10 is a view showing a display device according to another embodiment of the present invention.
FIG. 11 is a view showing a light system according to an embodiment of the present invention.

### DESCRIPTION OF THE PREFERRED EMBODIMENTS

In the following detailed description, only certain exemplary embodiments of the present invention have been shown and described, simply by way of illustration. As those skilled in the art would realize, the described embodiments may be modified in various different ways, all without departing from the scope of the present invention. Accordingly, the drawings and description are to be regarded as illustrative in nature and not restrictive. The invention is as defined in the appended claims.

In addition, when an element is referred to as being "on" another element, it may be directly on another element or be indirectly on another element with one or more intervening elements interposed therebetween.

Also, when an element is referred to as being "connected to" another element, it may be directly connected to the another element or be indirectly connected to the another element with one or more intervening elements interposed therebetween. Hereinafter, like reference numerals refer to like elements.

A light emitting device and a light emitting device package according to an embodiment of the present invention will be described in detail with reference to accompanying drawings.

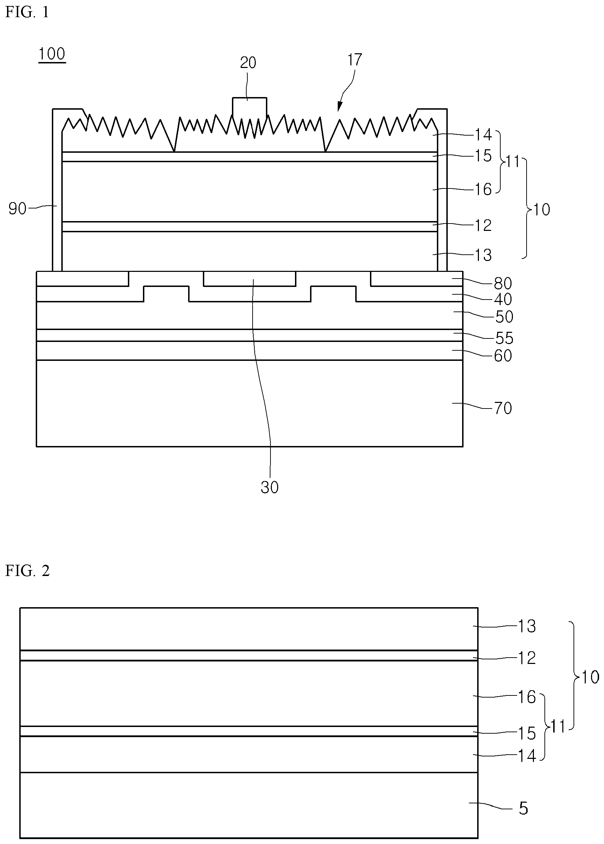

FIG. 1 is a view showing a light emitting device according to an embodiment of the present invention.

A light emitting device 100 according to an embodiment of the present invention comprises a light emitting structure 10, an electrode 20 and a reflective electrode 50 as shown in FIG. 1.

The light emitting structure 10 comprises a first conductive semiconductor layer (a first conductivity type semiconductor layer - to be referred to as such throughout the present disclosure) 11, an active layer 12 and a second conductive semiconductor layer (a second conductivity type semiconductor layer - to be referred to as such throughout the present disclosure) 13. The first conductive semiconductor layer 11 comprises a first semiconductor layer 14, a PEC etching control layer 15 and a second semiconductor layer 16. The roughness 17 may be provided on a top surface of the first semiconductor layer 14.

For example, the first conductive semiconductor layer 11 is formed as a n-type semiconductor layer to which n-type dopant may be added as a first conductive dopant, whereas, the second conductive semiconductor layer 13 may be formed as a p-type semiconductor layer to which p-type dopant is added as second conductive dopant. In addition, the first conductive semiconductor layer 11 may be formed as the p-type semiconductor layer and the second conductive semiconductor layer 13 may be formed as the n-type semiconductor layer. The first semiconductor layer 14 and the second semiconductor layer 16 may be implemented as the same conductive semiconductor layer.

For example, the first conductive semiconductor layer 11 may comprise the n-type semiconductor layer. The first conductive semiconductor layer 11 may be implemented as a compound semiconductor. For example, the first conductive semiconductor layer 11 may be implemented as III group-V group compound semiconductor. The first conductive semiconductor layer 11 may implement as III group-V group compound semiconductor.

The first conductive semiconductor layer 11 may be implemented by a semiconductor material having a composition formula of InₓAl_{y}Ga_{1-x-y}N (0≤x≤1, 0≤y≤1, 0≤x+y≤1). The first conductive semiconductor layer 11 may be selected from GaN, AlN, AlGaN, InGaN, InN, InAlGaN, AlInN, AlGaAs, GaP, GaAs, GaAsP, AlGaInP and the like and the n-type dopant of Si, Ge, Sn, Se, Te and the like may be doped.

The active layer 12 is defined as an layer joining electron (or hole) injected through the first conductive semiconductor layer 11 and hole (or electron) injected through the second conductive semiconductor layer 13 to emit light by difference of a band gap of an energy band according to a forming material of the active layer 12. The active layer 12 may be formed as any one of a single-well structure, a multi-well structure, a quantum dots or a quantum line structure but is not limited to thereto.

The active layer 12 may be implemented as a compound semiconductor. The active layer 12 may be implemented for example by a semiconductor material having a composition formula of InₓAl_{y}Ga_{1-x-y}N (0≤x≤1, 0<y<1, 0≤x+y≤1). When the active layer 12 is implemented by the multi-well structure, the active layer 12 may be implemented by stacking a plurality of well layer and a plurality of barrier layer, for example in cycle of InGaN well layer/GaN barrier layer.

For example, the second conductive semiconductor layer 13 may be implemented as the p-type semiconductor layer. The second conductive semiconductor layer 13 may be implemented as a compound semiconductor. For example, the second conductive semiconductor layer 13 may be implemented as III group-V group compound semiconductor. The second conductive semiconductor layer 13 may be implemented by a semiconductor material having a composition formula of InₓAl_{y}Ga_{1-x-y}N (0≤x≤1, 0<y<1, 0≤x+y≤1). The second conductive semiconductor layer 13 may be selected from GaN, AlN, AlGaN, InGaN, InN, InAlGaN, AlInN, AlGaAs, GaP, GaAs, GaAsP, AlGaInP and the like and may be doped with the p-type dopant such as Mg, Zn, Ca, Sr, Ba and the like.

Meanwhile, the first conductive semiconductor layer 11 may comprise the p-type semiconductor layer and the second conductivity type semiconductor layer 13 may comprise the n-type semiconductor layer. In addition, under the second conductive semiconductor layer 13, the semiconductor layer composed of the n-type or the p-type semiconductor layer may be further formed. Therefore, the light emitting structure 10 may comprise at least one of np, pn, npn, pnp junction structure. In addition, a doping concentration of impurities within the first conductive semiconductor layer 11 and the second conductive semiconductor layer 13 may be formed uniformly or unevenly. That is, the structure of the light emitting structure 10 may be variously formed, but is not limited thereto.

In addition, between the first conductive semiconductor layer 11 and the active layer 12, a first conducting InGaN/GaN super-lattice structure or InGaN/InGaN super-lattice super structure may be formed. In addition, between the second conductive semiconductor layer 13 and the active layer 12, AlGaN layer of the second conducting type may be formed.

The PEC etching control layer 15 is disposed between the first semiconductor layer 14 and the second semiconductor layer 16. The roughness 17 is provided on the top surface of the first semiconductor layer 14. An area of a portion of the PEC etching control layer 15 is exposed by the roughness 17. The roughness 17 is formed by the PEC etching scheme as will be described later. The PEC etching control layer 15 serves to prevent the etching of the second semiconductor layer 16 in process of performing the PEC etching. This prevents the active layer 12 to be damaged due to PEC etching. According to the embodiment of the present invention, the roughness 17 is formed by the PEC etching to prevent the active layer 12 to be damaged, thereby improving light efficiency of the light emitting device.

The PEC etching control layer 15 may comprise an insulating layer. For example, the PEC etching control layer 15 may be implemented as the insulating layer containing A1.

The PEC etching control layer 15 comprises an AlN layer. The PEC etching control layer 15 is implemented as a layer which is not etched by the PEC etching process. This prevents the second semiconductor layer 16 and the active layer 12 deposed in the lower part of the PEC etching control layer 15 to be etched by the PEC manners. The PEC etching control layer 15 may be formed of a light transmitting material.

The PEC etching control layer 15 is formed of a layer having a carrier concentration of 0. The etching is performed by electrons exchange in process of PEC etching. In this case, PEC over etching toward the second semiconductor layer 16 and the active layer 12 can be prevented as the carrier concentration of the PEC etching control layer 15 comes to zero (0). That is, the PEC etching control layer 15 is expressed as a layer having an activated doping concentration of zero (0). For example, when the first conductive semiconductor layer 11 is formed as n-type semiconductor layer, the PEC etching control layer 15 may be formed through the p-type doping capable of providing a hole corresponding to electron concentration. For example, Mg dopant may be used as the p-type doping. In addition, the energy band gap for the PEC etching control layer 15 may be implemented as greater than that of the first conductive semiconductor layer 11.

This can prevent the PEC etching control layer 15 to be etched in process of PEC etching.

The roughness 17 is provided on the top surface of the first semiconductor layer 14. The roughness 17 is implemented by the PEC etching. When the first semiconductor layer 14 is GaN layer, a surface having the roughness 17 may be N-face considering growth direction and etching direction.

Under the light emitting structure 10, an ohmic contact layer 40 and the reflective electrode 50 may be disposed. The electrode 20 may be disposed on the light emitting structure 10. The electrode 20 and the reflective electrode 50 provide a power supply to the light emitting structure 10. The ohmic contact layer 40 may be formed to perform an ohmic contact with the light emitting structure 10. The ohmic contact layer 40 can perform the ohimic contact with the second conductive semiconductor layer 13. In addition, the reflective electrode 50 reflects light incident from the light emitting structure 10 to increase an amount of light extracted toward the outside.

The ohmic contact layer 40 for example, may be formed as transparent conductive oxide layer. For example, the ohmic contact layer 40 may be formed as at least one material selected from ITO(Indium Tin Oxide), IZO(Indium Zinc Oxide), AZO(Aluminum Zinc Oxide), AGZO(Aluminum Gallium Zinc Oxide), IZTO(Indium Zinc Tin Oxide), IAZO(Indium Aluminum Zinc Oxide), IGZO(Indium Gallium Zinc Oxide), IGTO(Indium Gallium Tin Oxide), ATO(Antimony Tin Oxide), GZO(Gallium Zinc Oxide), IZON(IZO Nitride), ZnO, IrOx, RuOx, NiO.

The reflective electrode 50 may be formed of metal material having a high reflectance. For example, the reflective electrode 50 may be formed of metal or alloy composed of at least one of Ag, Ni, Al, Rh, Pd, Ir, Ru, Mg, Zn, Pt, Cu, Au and Hf. In addition, the reflective electrode 50 may be formed as a multilayer using an light transmitting conductive material such as the metal or the alloy and ITO(Indium-Tin-Oxide), IZO(Indium-Zinc-Oxide), IZTO(Indium-Zinc-Tin-Oxide), IAZO(Indium- Aluminum-Zinc-Oxide), IGZO(Indium-Gallium-Zinc-Oxide), IGTO(Indium-Gallium-Tin-Oxide), AZO(Aluminum-Zinc-Oxide), ATO(Antimony-Tin-Oxide) and the like. For example, in an embodiment, the reflective electrode 50 may comprise at least one of Ag, Al, alloy of Ag-Pd-Cu or alloy of Ag-Cu.

Between light emitting structure 10 and the ohmic contact layer 40, a current blocking layer (CBL) 30 may be disposed. The current blocking layer 30 may be formed in an area in which at least of a portion thereof overlaps with the electrode 20 in the vertical direction. The current blocking layer 30 serves to reduce a concentrating phenomenon of current on a shortest distance between the electrode 20 and the reflective electrode 40.

Therefore, light emitting device according to the embodiment of the present invention improves light emitting efficiency.

The current blocking layer 30 has an electrical insulating property or may be formed using material forming Schottky contact with the light emitting structure 10. The current blocking layer 30 may be formed of oxide, nitride and metal. The current blocking layer 30 comprises at least one of SiO₂, SiOₓ, SiOₓN_{y}, Si₃N₄, Al₂O₃, TiOₓ, Ti, Al and Cr.

The current blocking layer 30 may be disposed at first area under the light emitting structure 10. The ohmic contact layer 40 may be disposed at second area under the light emitting structure 10 and disposed under the current blocking layer 30. The ohmic contact layer 40 may be disposed between the light emitting structure 10 and the reflective electrode 50. The ohmic contact layer 40 may be disposed between the current blocking layer 30 and the reflective electrode 50.

Between the light emitting structure 10 and the ohmic contact layer 40, an isolation layer 80 may be disposed. The isolation layer 80 may be disposed around the bottom of the light emitting structure 10. The isolation layer 80 may be disposed on the ohmic contact layer 40. For example, the isolation layer 80 may be formed of a material having an electrical insulating properties or a material having a lower electrical conductivity than that of the light emitting structure10. The isolation layer 80, for example, may be formed of oxide or nitride. For example, the isolation layer 80 may be formed to select at least one from group composed of Si0₂, SiₓO_{y}, Si₃N₄, SiₓN_{y}, SiOₓN_{y}, Al₂O₃, TiO₂, ITO, AZO, ZnO and the like. The isolation layer 80 may be formed of a material such as the current blocking layer 30 or may be formed of a material different from each other. The isolation layer 80 may refers to as a channel layer.

Under the reflective electrode 50, a diffusion barrier layer 55, a bonding layer 60 and a conductive support member 70 may be disposed.

The diffusion battier layer 55 is to prevent a material included in the bonding layer 60 to be diffused toward the reflective electrode 50. The diffusion barrier layer 55 is to prevent a material such as tin (Sn) and the like included in the bonding layer 60 to affect the reflective electrode 50. The diffusion barrier layer 55 may comprises at least one of materials of Cu, Ni, Ti-W, W and Pt.

The bonding layer 60 may comprise barrier metal or bonding metal and the like such as at least one of Ti, Au, Sn, Ni, Cr, Ga, In, Bi, Cu, Ag or Ta. The conductive support member 70 supports the light emitting element according to an embodiment of the present invention and is electrically connected with an external electrode to provide the power supply to the light emitting structure 10. The conductive support member 70 may be formed as at least one of Ti, Cr, Ni, Al, Pt, Au, W, Cu, Mo, Cu-W or a semiconductor substrate injected with impurities (for example, Si, Ge, GaN, GaAs, ZnO, SiC, SiGe and the like).

The protective layer 90 may be further disposed on the light emitting structure 10. The protective layer 90 may be formed of oxide or nitride. The protective layer 90 may be formed of a material having light transmitting property and insulation property such as SiO₂, SiOₓ, SiOₓN_{y}, Si₃N₄, Al₂O₃.

The protective layer 90 may be disposed at side surface of the light emitting structure 10. The protective layer 90 may be disposed at the side surface and the top of the light emitting structure 10.

The description described above was mainly made regarding the light emitting device having a vertical structure in which an electrode 20 is disposed at the top of the light emitting structure 10 and the reflective electrode 50 is disposed at bottom of the light emitting structure 10. However, the light emitting device according to an embodiment of the present invention may variously change a shape and position of a first electrode connected electrically to the first conductive semiconductor layer 11 composed the light emitting structure 10 and a second electrode electrically connected to the second conductive semiconductor layer 13. In addition, the light emitting device may apply to a light emitting device of horizontal structure exposed to the first and second electrode in the same direction.

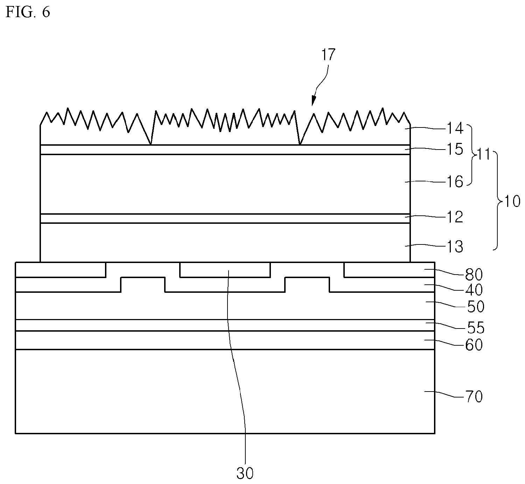

A method of fabricating light emitting device according to an embodiment will be described with reference to FIGS. 2 to 7.

According to a method of fabricating light emitting device according to the embodiment of the present application, as described in FIG. 2, the first conductive semiconductor layer 11, the active layer 12 and the second conductive semiconductor layer 13 are formed on the substrate 5. The first conductive semiconductor layer 11, the active layer 12 and the second conductive semiconductor layer 13 are defined as the light emitting structure 10.

The substrate 5 may be formed of at least one of sapphire substrate (Al2O3), SiC, GaAs, GaN, ZnO, Si, GaP, InP and Ge, but is not limited to thereto. Between the first conductive semiconductor layer 11 and the substrate 5, a buffer layer maybe further formed.

The first conductive semiconductor layer 11 comprises the first semiconductor layer 14, the PEC etching control layer 15 and the second semiconductor layer 16. The first semiconductor layer 14, the PEC etching control layer 15 and the second semiconductor layer 16 are sequentially grown.

The PEC etching control layer 15 serves to prevent the etching of the second semiconductor layer 16 in process of etching as will be described later. Therefore, the PEC etching control layer 15 can prevent the damage of the active layer 12 from the PEC etching.

The PEC etching control layer 15 may comprises the insulating layer. The PEC etching control layer 15 comprises AlN layer. The PEC etching control layer 15 is implemented as layer that is not etched in process of the PEC etching.

The PEC etching control layer 15 is implemented as a carrier concentration of zero (0). The etching according to an electron exchange in process of the PEC etching is performed. In this case, the PEC over etching moving into the second semiconductor layer 16 and the active layer 12 can be prevented as the PEC etching control layer 15 reaches the carrier concentration of zero (0). The PEC etching control layer 15 is implemented as a layer having activated dopant concentration of zero (0). For example, when the first conductive semiconductor layer 11 is implemented as the n-type semiconductor layer, the PEC etching control layer 15 may be implemented through a p-type doping capable of providing the hole corresponding to the electron. For example, the Mg dopant may be used as the p-type doping. In addition, the PEC etching control layer 15 may be implemented as a material having a larger energy band gap than that of the first conductive semiconductor layer 11. Therefore, the etching of the PEC etching control layer 15 is prevented in process of the PEC etching.

For example, the first conductive semiconductor layer 11 may be formed as the n-type semiconductor layer added with the n-type dopant as the first conductive dopant and the second conductive semiconductor layer 13 may be formed as the p-type semiconductor layer added with p-type dopant as the second conductive dopant. In addition, the first conductive semiconductor layer 11 is formed as the p-type semiconductor layer and the second conductive semiconductor layer 13 is formed as the n-type semiconductor layer.

For example, the conductive semiconductor layer 11 may comprise the n-type semiconductor layer. The first conductive semiconductor layer 11 may be formed of a semiconductor of material having the composition formula of InₓAl_{y}Ga_{1-x-y}N (0≤x≤1, 0≤y≤1, 0≤x+y≤1). The first conductive semiconductor layer 11 may be selected from InAlGaN, GaN, AlGaN, AlInN, InGaN, AlN, InN and the like and the n-type dopant such as Si, Ge, Sn and the like may be doped.

The active layer 12 is defined as a layer to join electron (or hole) injected through the first conductive semiconductor layer 11 and hole (or electron) injected through the second conductive semiconductor layer 13 to emit light by difference of the band gap of the energy band according to a formation material of the active layer 12. The active layer 12 is formed as any one of a single-well structure, a multi-well structure, a quantum dot structure and a quantum line structure, but is not limited to thereof

The active layer12 may be formed of a material having the composition formula of InₓAl_{y}Ga_{1-x-y}N (0≤x≤1, 0≤y≤1, 0≤x+y≤1. When the active layer is formed as the multi-well, the active layer a plurality of well layers and a plurality of the barrier layer, for example, is formed in cycle of InGaN well layer/GaN barrier layer.

The second conductive semiconductor 13, for example, may be implemented as the p-type semiconductor. The second conductive semiconductor layer 13 may be formed as a semiconductor material having a composition formula of InₓAl_{y}Ga_{1-x-y}N (0≤x≤1, 0≤y≤1, 0≤x+y≤1). The second conductive semiconductor layer 13, for example, may select from InAlGaN, GaN, AlGaN, InGaN, AlInN, AlN, InN and the like and the p-type dopant of Mg, Zn, Ca, Sr, Ba and the like may be doped.

Meanwhile, the first conductive semiconductor layer 11 comprises the p-type semiconductor layer and the second conductive semiconductor layer 13 comprises the n-type semiconductor layer. In addition, the semiconductor layer comprising the n-type or p-type semiconductor layer may be further formed on the second conductive semiconductor layer 13. Therefore, the light emitting structure 10 may comprise at least one of np, pn, npn and pnp junction structure. In addition, the average doping concentration of impurities within the first conductive semiconductor layer 11 and the second conductive semiconductor layer 13 may be formed uniformly or unevenly. That is, the structure of the light emitting structure 10 may be variously formed, but is not limited to thereto.

In addition, between the first conductive semiconductor layer 11 and the active layer 12, the first conducting InGaN/GaN super-lattice structure or InGaN/InGaN supper-lattice structure may be formed. In addition, between the second conductive semiconductor layer 13 and the active layer 12, a second conducting type AlGaN layer may be formed.

Subsequently, the current blocking layer 30 may be formed on the second conductive semiconductor layer 13 and the isolation layer 80 is formed on the second conductive semiconductor layer 13. The current blocking layer 30 and the isolation layer 80 may be selectively formed. The current blocking layer 30 and the isolation layer 80 may be simultaneously or sequentially formed.

The current blocking layer 30 has an electrical insulating property or may be formed using a material forming the schottky contact with the light emitting structure 10. The current blocking layer 30 may be formed as oxide, nitride or metal. The current blocking layer 30, for example, may comprise at least one of SiO2, SiOₓ, SiOₓN_{y}, Si₃N₄, Al₂O₃, TiOₓ, Ti, Al and Cr. The isolation layer 80 may be formed as a material having an electrical insulating property or a material having an electrical conductivity lower than that of the light emitting structure10. For example, the isolation layer 80 may be formed as oxide or nitride. For example, the isolation layer 80 may be formed to select at least one from a group consisting of Si0₂, SiₓO_{y}, Si₃N₄, SiₓN_{y}, SiOₓN_{y}, Al₂O₃, TiO₂, ITO, AZO, ZnO and the like. The isolation layer 80 may be formed as a material such as the current blocking layer 30 and may be formed as a different material. The isolation layer 80 may be referred as a channel layer.

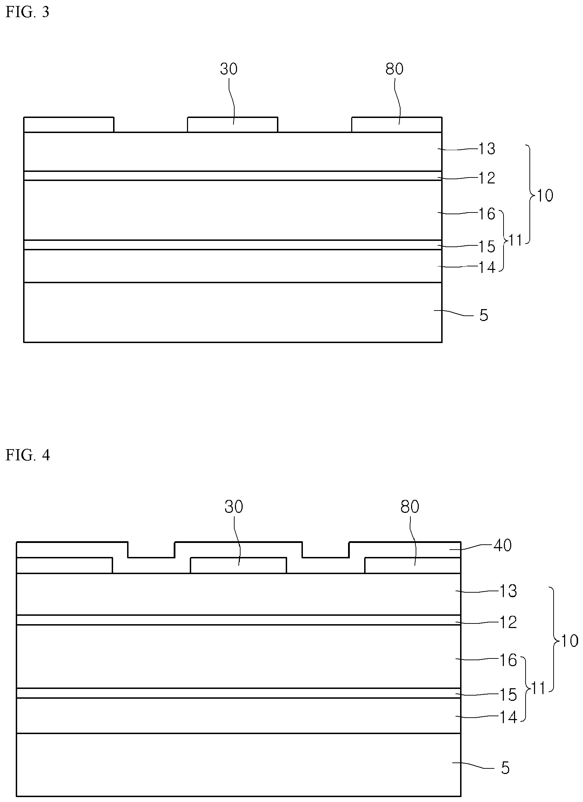

In addition, the ohmic contact layer 40 is formed on the current blocking layer 30 and the isolation layer 80 as shown in FIG. 4.

The ohmic contact layer 40 may be formed to perform the ohmic contact with the light emitting structure 10. For example, the ohmic contact layer 40 may be formed as the transparent conductive oxide layer. The ohmic contact layer 40 may be formed as at least one material selected from ITO(Indium Tin Oxide), IZO(Indium Zinc Oxide), AZO(Aluminum Zinc Oxide), AGZO(Aluminum Gallium Zinc Oxide), IZTO(Indium Zinc Tin Oxide), IAZO(Indium Aluminum Zinc Oxide), IGZO(Indium Gallium Zinc Oxide), IGTO(Indium Gallium Tin Oxide), ATO(Antimony Tin Oxide), GZO(Gallium Zinc Oxide), IZON(IZO Nitride), ZnO, IrOx, RuOx and NiO.

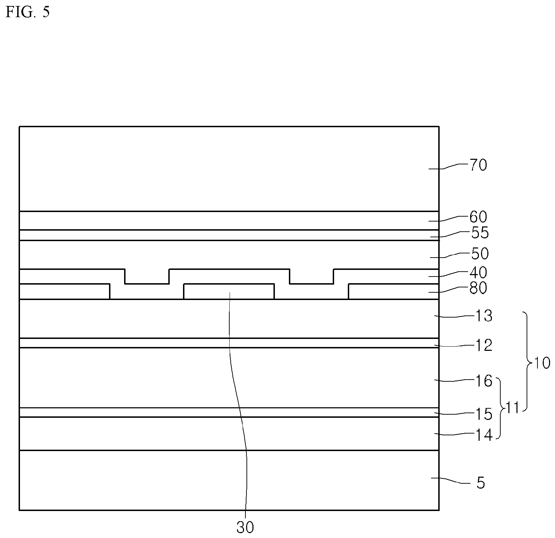

Subsequently, the reflective electrode 50, the diffusion barrier layer 55, the bonding layer 60 and conductive support member 70 is formed on the ohmic contact layer 40 as shown in FIG. 5.

The reflective electrode 50 may be formed as a metal material having high reflectance. For example, the reflective electrode 50 may be formed as metal or alloy composed of at least one of Ag, Ni, Al, Rh, Pd, Ir, Ru, Mg, Zn, Pt, Cu, Au and Hf. In addition, the reflective electrode 50 may be formed as a multi-layers using the light transmitting conductive material such as the metal or the alloy and ITO(Indium-Tin-Oxide), IZO(Indium-Zinc-Oxide), IZTO(Indium-Zinc-Tin-Oxide), IAZO(Indium-Aluminum-Zinc-Oxide), IGZO(Indium-Gallium-Zinc-Oxide), IGTO(Indium-Gallium-Tin-Oxide), AZO(Aluminum-Zinc-Oxide), ATO(Antimony-Tin-Oxide) and the like. For example, in the embodiment, the reflective electrode 50 may comprise at least one of Ag, Al, Ag-Pd-Cu alloy or Ag-Cu alloy.

The diffusion barrier layer 55 serves to prevent a material included in the bonding layer 60 to be diffused into a direction of the reflective electrode 50. The diffusion barrier layer 55 serves to prevent a material such as tin (Sn) and the like included in the bonding layer 60 to affect the reflective electrode 50. The diffusion barrier layer 55 may comprise at least one of materials of Cu, Ni, Ti-W, W, Pt and the like.

The bonding layer 60 may comprise barrier metal or bonding metal and the like and may comprise at least one of Ti, Au, Sn, Ni, Cr, Ga, In, Bi, Cu, Ag or Ta. The conductive support member 70 supports the light emitting device according to the embodiment of the present invention and is electrically connected to the external electrode to provide the power supply to the light emitting structure 10. The conductive support member 70 may be formed as at least one of Ti, Cr, Ni, Al, Pt, Au, W, Cu, Mo, Cu-W or the semiconductor substrate injected with the impurities (for example, Si, Ge, GaN, GaAs, ZnO, SiC, SiGe and the like).

Next, the substrate 5 is removed from the light emitting structure 10. For one example, the substrate 5 may be removed by a laser lift off (LLO) process. The laser lift off process LLO is to irradiates a laser to the bottom of the substrate 5 to peel the substrate 5 from the light emitting structure 10.

In addition, the roughness 17 is formed at the top surface of the first conductive semiconductor layer 11. The roughness 17 formed on the top surface of the first conductive semiconductor layer 11 is formed by the PEC etching process.

The PEC etching control layer 15 is disposed between the first semiconductor layer 14 and the second semiconductor layer 16. The roughness 17 is provided on the top surface of the first semiconductor layer 14. A portion of area of the PEC etching control layer 15 is exposed by the roughness 17. The PEC etching control layer 15 serves to prevent the second semiconductor layer 16 to be etched in process of PEC etching the damage of the active layer 12 by the PEC etching may be prevented. The embodiment described above forms the roughness 17 using the PEC etching to prevent the active layer 12 to be damaged, thereby improving light efficiency of the light emitting device.

The PEC etching control layer 15 may comprise an insulating layer. The PEC etching control layer 15 comprises an AlN layer. The PEC etching control layer 15 is implemented as a layer that the etching is not performed in process of the PEC etching. This prevents the second semiconductor layer 16 and the active layer 12 positioned at the lower of the PEC etching control layer 15 to be etched.

The PEC etching control layer 15 is implemented as the carrier concentration of zero (0). The etching according to the electron exchange in process of the PEC etching is performed. In this case, the PEC over etching toward the second semiconductor layer 16 and the active layer 12 may be prevented as the carrier concentration of zero (0) of the PEC etching control layer 15 is implemented. That is, the PEC etching control layer 15 is expressed as the actived doping concentration of zero (0). For example, when the first conductive semiconductor layer 11 is implemented as the n-type semiconductor, the PEC etching control layer 15 may be implemented through the p-type doping providing the hole corresponding to the electron. For example, Mg dopant may be used as the p-type doping. In addition, the PEC etching control layer 15 may be implemented as a larger energy band gap than that of the first conductive semiconductor layer 11. This prevents the PEC etching control layer 15 to be etched in process of the PEC etching.

The roughness 17 is provided on the top surface of the first semiconductor layer 14. When the first semiconductor layer 14 is GaN layer, the surface forming the roughness 17 may be N-face.

Meanwhile, the isolation etching is performed along a boundary of a separate chip of the light emitting structure 10, so that a plurality of the light emitting device may be classified into a separate light emitting device unit. The isolation etching may be formed by for example, a dry etching such as an inductively coupled plasma (ICP), but is not limited to thereto. According to an embodiment of the present invention, first, the isolation etching is performed and then the roughness 17 may be formed through the PEC etching. In addition, the isolation etching may be also performed after performing the PEC etching.

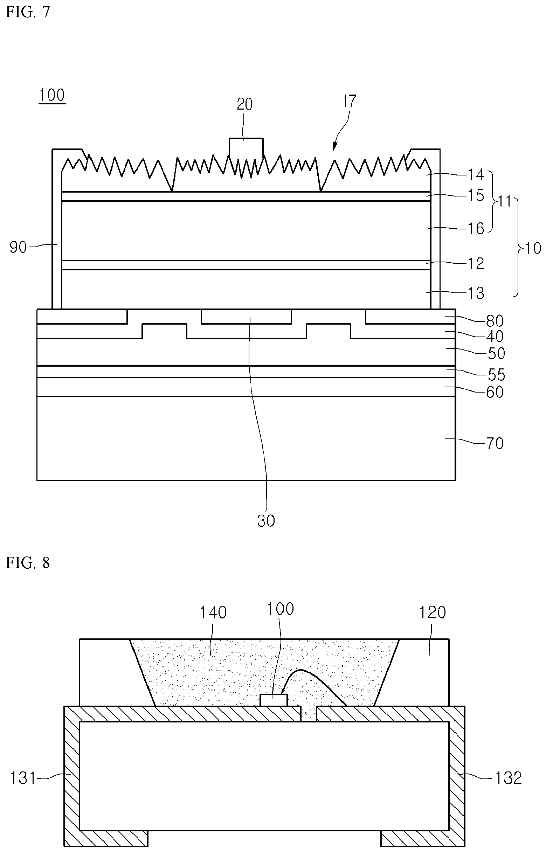

Referring FIG. 7, the protective layer 90 may be formed on at least one side surface of the light emitting structure 10. The protective layer 90 prevents the light emitting structure 10 to electrically be shorted for the external electrode or the electrode 20 and the like.

For example, the protective layer 90 may be formed as oxide or nitride. For example, the protective layer 90 may be formed as a material having the light transmitting property and the insulating property such as SiO₂, SiOₓ, SiOₓN_{y}, Si₃N₄ and Al₂O₃. For example, the protective layer 90 may be formed by a deposition scheme such as an electron beam deposition, a PECVD and a sputtering.

Next, the electrode 20 is electrically connected to the light emitting structure 10. The electrode 20 provides the power supply to the light emitting structure 10 together with the reflective electrode 50 and may be formed to overlap partially with the current blocking layer 31 in a vertical direction. The above described electrode 20 forming process and the protective layer 90 forming process have various modification according to the design and process thereof

FIG. 8 is a view showing the light emitting device package applied with the light emitting device.

Referring to FIG. 8, the light emitting device package according to an embodiment of the present invention comprises a body 120, a first lead electrode 131 and a second lead electrode 132 disposed at the body 120, a light emitting device 100 according to an embodiment located at the body 120 electrically connected with the first lead electrode 131 and the second lead electrode 132 and a molding member 140 surrounding the light emitting device 100.

The body 120 may be formed to comprise at least one of a silicon material, a synthetic resin material or a metal material and the inclined plan is formed around the light emitting device 100.

The first lead electrode 131 and the second lead electrode 132 is electrically separated each other and provides the power supply to the light emitting device 100. In addition, the first lead electrode 131 and the second lead electrode 132 is to reflects the light generated from the light emitting device 100 to increase light efficiency and to discharge heat generated from the light emitting device 100 into the outside.

The light emitting device 100 is disposed on the body 120 or the first lead electrode 131 or the second electrode 132.

The light emitting device 100 may electrically connected with the first lead electrode 131 and the second lead electrode 132 by at least of a wire method, a flip-chip method or die bonding method.

The molding member 140 surrounds the light emitting device 100 to protect the light emitting device 100. In addition, the molding member 140 comprises a fluorescent body to vary a wavelength of the light emitted from the emitting device 100.

A plurality of the light emitting device or the light emitting device package according to the embodiment of the present invention may be arrayed on the board in plural and an optical member such as a lens, a light guide plate, a prism sheets, diffusion sheet and the like may be disposed on the light path of the light emitting device package. The light emitting device package, a board, an optical member may serve as a light unit. The light unit is implemented as a top-view type or a side-view type or is provided to a display such as a portable terminal, a notebook and the like or is variously applied to a lighting device and an indicating device. Another embodiment of the present invention may be implemented as a light device comprising the light emitting device or the light emitting device package described in the embodiment of the present invention. For example, the light device comprises a lamp, a street lamp, electronic display and a headlamp.

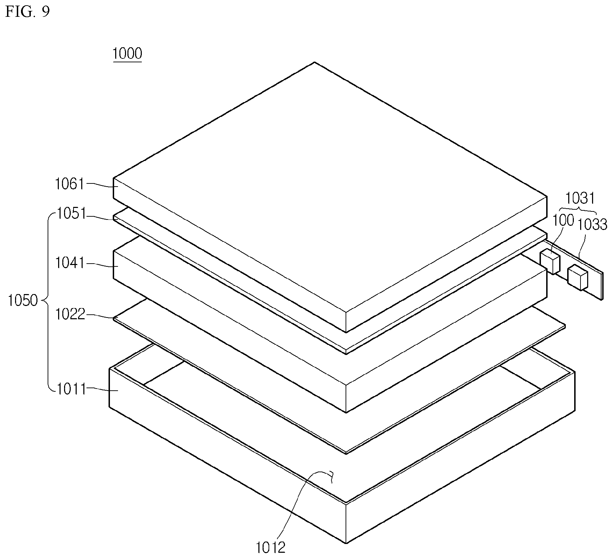

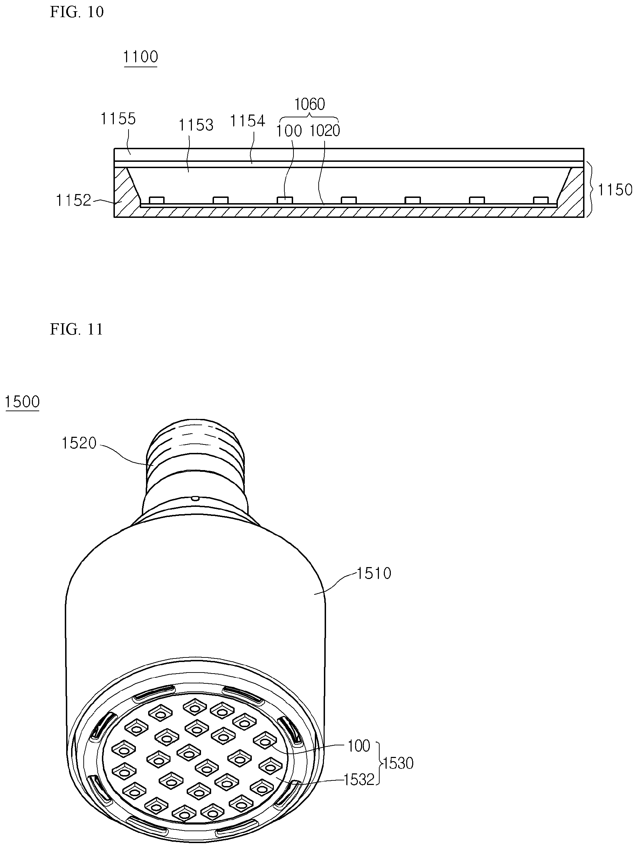

The light emitting device according to the embodiment of the present invention may be applied to the light unit. The light unit comprises a structure in which a plurality of light emitting devices is arrayed, a display device shown FIGS. 9 and 10, and the light device showing in FIG. 11.

Referring to FIG.9, a display device 1000 according to an embodiment of the present invention comprises a light guide plate 1041, a light emitting module 1031 providing light to the light guide plate 1041, a reflective member 1022 under the light guide plate 1041, an optical sheet 1051 on the light guide plate 1041, a display panel 1061 on the optical sheet 1051 and bottom cover 1011. The bottom cover 1011 receives the light guide plate 1041, the light emitting module 1031 and the reflective member 1022, but limited to thereto.

The light guide plate 1041 diffuses light and performs a surface light source using the diffused light. The light guide plate 1041 may be composed of a transparent material, for example, comprise at least one of acrylic resin family such as PMMA (polymethyl metaacrylate), polyethylene terephthlate (PET), poly carbonate (PC), cycloolefin copolymer (COC) and polyethylene naphthalate (PEN).

The light emitting module 1031 provides light to at least one of the light guide plate 1041 and ultimately functions as a light source of the display device.

At least one light emitting module 1031 may be provided and the light emitting module 1031 may provide directly or indirectly light to one side of the light guide plate 1041. The light emitting module 1031 may comprise a board 1033 and the light emitting device 100 according to the above described light emitting device 100. The light emitting device 100 may be arrayed on the board 1033 in a predetermined distance.

The board 1033 may be a printed circuit board (PCB). However, the board 1033 may comprise PCB, metal core PCB (MCPCB), flexible PCB (FPCB) and the like, but is not limited to thereto. When the light emitting device 100 is provide on a side surface of the bottom cover 1011 or a heat sink plate, the board 1033 may be removed. Here, a portion of the heat sink plate may be contacted on top surface of the bottom cover 1011.

In addition, a plurality of light emitting 100 may be mounted such that a projecting surface emitting light is spaced apart from the light guide plate 1041, but is not limited to thereto. The light emitting device 200 may directly or indirectly provide light to an incident light section such as one side surface of the light guide plate 1041, but is not limited to thereto.

The reflective member 1022 is disposed under the light guide plate 1041. A luminance of the light unit 1050 may be improved by reflecting light incident on lower surface of the light guide plate 1041 and directing the reflected light upwardly using the reflective member 1022. The reflective member 1022 may be formed as PET, PC, PVC resin and the like, but is not limited to thereto. The reflective member 1022 may be a top surface of the bottom cover 1011 but is not limited thereto.

The bottom cover 1011 receives the light guide plate 1041, the light emitting module 1031 and the reflective member 1022. To this end, the bottom cover 1011 comprises a receiving section 1012 having a top surface opened- box shape, but is not limited to thereto. The bottom cover 1011 may be combined with the top cover, but is not limited to thereto.

The bottom cover 1011 may be formed as metal material or plastic material and may be fabricated using a press mold or an extrude mold. In addition, the bottom cover 1011 comprises metal or non-metallic material having a good thermal conductivity, but is not limited to thereto.

For example, the display panel 1061 is LCD panel. In this case, the display panel comprises a first and second substrate opposite each other made of transparent material and a liquid crystal layer interposed between the first substrate and second substrate. At least one surface of the display panel 1061 is attached with a polarizing plate but is not limited to the attached structure of polarizing plate. The display panel 1061 displays information by light pass through the optical sheet 1051. The display device 1000 may apply various portable terminal, a monitor of the notebook computer, a monitor of laptop computer, a television and the like.

The optical sheet 1051 is disposed between the display panel 1061 and the light guide plate 1041 and comprises at least one sheet of the light transmitting property. The optical sheet 1051 may comprise at least one of sheets such as a diffusion sheet, a horizontal and vertical prism sheet and a luminance enhancing sheet. The diffusion sheet diffuse light to be incident, the horizontal or/and the vertical prism sheet concentrates light to be incident on the display area and the luminance enhancing sheet enhances the luminance by reusing a lost light. In addition, the protective sheet may be disposed on the display panel 1061, but is not limited to thereto.

Herein, a least one of the light guide plate 1041 and the optical sheet 1051 may be disposed on the light path of the light emitting module 1031, but is not limited to thereto.

FIG. 10 is a view showing another embodiment of display device according to an embodiment of the present invention.

Referring to FIG. 10, the display device 1100 comprises a bottom cover 1152, a board 1020 in which the above described light emitting device 100 is arrayed, an optical member 1154 and a display panel 1155.

The board 1020 and the light emitting device 100 may define the light emitting module 1060. The bottom cover 1152, at least one light emitting module 1060 and the optical member 1154 may define as the light unit.

The bottom cover 1152 may be provided with the receiving section 1153, but is not limited to thereto.

Herein, the optical member 1154 may comprise at least one of a lens, a light guide plate, a diffusion sheet, a horizontal and vertical prism sheet and a luminance enhancing sheet and the like. The light guide plate may be formed of PC material or poly methyl methacrylate (PMMA) material and the light guide plate may be removed. The diffusion sheet diffuse light to be incident, the horizontal or/and the vertical prism sheet concentrates the light to be incident on the display area and the luminance enhancing sheet enhances the luminance by reusing a lost light.

The optical member 1154 may be disposed on the light emitting module 1060 and perform a surface light source, diffusion, concentration and the like on light emitted from the light emitting module 1060.

FIG. 11 is a perspective view showing a light device according to the embodiment of the present invention.

Referring FIG. 11, the light device 1500 may comprise a case 1510, a light emitting module 1530 mounted to the case 1510 and a connecting terminal 1520 disposed in the case 1510 and receiving a power supply from an external power supply.

The case 1510 may be formed as a good material having a heat sink property and for example, be formed as a metal material or a resin material.

The light emitting module 1530 comprises a board 1532 and the light emitting device 100 according to the above described disposed on the board 1532. The light emitting device 100 may be arrayed in matrix form in plural or be arrayed to space in predetermined interval.

The board 1532 may be one of a printed circuit board (PCB), a metal core PCB, a flexible PCB, a ceramic PCB, FR-4 board.

In addition, the board 1532 may be formed as material efficiently reflecting light or color efficiently reflecting light, for example is implemented as a coating layer such as white color, silver color and the like.

The board 1532 may be disposed with at least one light emitting device 100. The light emitting device 100 may comprise at least one light emitting diode chip. The LED chip may comprise a colored light emitting diode emitting colored light of red, green, blue or white and a UV light emitting diode emitting an ultra violet.

The light emitting module 1530 may be disposed to have a combination of various light emitting device 100 to obtain color gamut and a luminance. A white light emitting diode, a red light emitting diode and a green light emitting diode are combined and disposed to obtain a high color rendering index (CRI).

The connecting terminal 1520 is electrically to the light emitting module 1530 to supply a power supply.

The connecting terminal 1520 may be connected to the external power supply in socket manners but is not limited to thereto. For example, the connecting terminal 1520 may be formed in a pin form to be inserted into the external power supply or may be connected to the external power supply by a wiring.

The above described light emitting device 200 is packaged and then is mounted on the board to implement the light emitting module or is mounted and packaged in a LED chip form to implement the light emitting module.

A light emitting device, and method of fabricating light emitting device, a light emitting device package, and light unit form roughness on a light emitting structure using a PEC etching scheme to prevent a active layer composed of a light emitting structure to be damaged.

While the present invention has been described in connection with certain exemplary embodiments, it is to be understood that the invention is not limited to the disclosed embodiments, but, on the contrary, is intended to cover various modifications included within the scope of the appended claims.

## Claims

1. A light emitting device comprising:
a first conductivity type semiconductor layer (11) providing a roughness (17) on an upper surface thereof and comprising a photo electrochemical (PEC) etching control layer (15);
an active layer (12) under the first conductivity type semiconductor layer (11);
a second conductivity type semiconductor layer (13) under the active layer (12);
a reflective electrode (50) electrically connected to the second conductivity type semiconductor layer (13); and
a first electrode (20) electrically connected to the first conductivity type semiconductor layer (11),
wherein the first conductivity type semiconductor layer (11) comprises a first semiconductor layer (14) and a second semiconductor layer (16), wherein said PEC etching control layer (15) is disposed between the first semiconductor layer (14) and the second semiconductor layer (16), said roughness (17) being provided on a top surface of said first semiconductor layer (14);
**characterized in that**
the PEC etching control layer (15) comprises AlN layer and has an activated doping concentration of zero (0);
and **in that** an area of a portion of the PEC etching control layer (15) is exposed by the roughness (17).

2. The light emitting device according to claim 1, further comprising an ohmic contact layer (40) disposed between the reflective electrode (50) and the second conductivity type semiconductor layer (13).

3. A method of fabricating light emitting device comprising:
forming a first conductivity type semiconductor layer (11) on a substrate (5), said first conductivity type semiconductor layer (11) comprising a first semiconductor layer (14), a second semiconductor layer (16) and a PEC etching control layer (15) between the first semiconductor layer (14) and the second semiconductor layer (16);
forming an active layer (12) on the first conductivity type semiconductor layer (11);
forming a second conductivity type semiconductor layer (13) on the active layer (12);
forming a reflective electrode (50) on the second conductivity type semiconductor layer (13);
forming a support member (70) on the reflective electrode (50) ;
removing the substrate (5); and
performing a PEC etching on the exposed first conductivity type semiconductor layer (11) to form a roughness (17) on a top surface of the first conductivity type semiconductor layer (11),
**characterized in that**
the PEC etching control layer (15) comprises AlN layer and has an activated doping concentration of zero (0), and **in that** an area of a portion of said PEC etching control layer (15) is exposed by the roughness (17).

4. A light emitting device package comprising:
a body;
a light emitting device disposed on the body and according to any one of claims 1 to 2; and
a first lead electrode and a second lead electrode electrically connected to the light emitting device.

5. A light unit comprising:
a board;
a light emitting device disposed on the board and according to any one of claims 1 to 2; and
an optical member passing light provided from the light emitting device.

## Patentansprüche

1. Lichtemittierungsvorrichtung umfassend:
eine Halbleiterschicht eines ersten Leitfähigkeitstyps (11), die eine Rauigkeit (17) an einer oberen Oberfläche von dieser bereitstellt und eine photoelektrochemische (PEC)-Ätzsteuerschicht (15) umfasst;
eine aktive Schicht (12) unter der Halbleiterschicht des ersten Leitfähigkeitstyps (11);
eine Halbleiterschicht eines zweiten Leitfähigkeitstyps (13) unter der aktiven Schicht (12);
eine reflektierende Elektrode (50), die mit der Halbleiterschicht des zweiten Leitfähigkeitstyps (13) elektrisch verbunden ist; und
eine erste Elektrode (20), die mit der Halbleiterschicht des ersten Leitfähigkeitstyps (11) elektrisch verbunden ist,
wobei die Halbleiterschicht des ersten Leitfähigkeitstyps (11) eine erste Halbleiterschicht (14) und eine zweite Halbleiterschicht (16) umfasst, wobei die PEC-Ätzsteuerschicht (15) zwischen der ersten Halbleiterschicht (14) und der zweiten Halbleiterschicht (16) angeordnet ist,
wobei die Rauigkeit (17) an einer oberen Oberfläche der ersten Halbleiterschicht (14) bereitgestellt ist;
**dadurch gekennzeichnet, dass**
die PEC-Ätzsteuerschicht (15) eine AlN-Schicht umfasst und eine aktivierte Dotierkonzentration von Null (0) aufweist;
und dass ein Bereich eines Abschnitts der PEC-Ätzsteuerschicht (15) durch die Rauigkeit (17) exponiert ist.

2. Lichtemittierungsvorrichtung nach Anspruch 1, ferner umfassend eine Ohmsche Kontaktschicht (40), die zwischen der reflektierenden Elektrode (50) und der Halbleiterschicht des zweiten Leitfähigkeitstyps (13) angeordnet ist.

3. Verfahren zum Herstellen einer Lichtemittierungsvorrichtung umfassend:
Bilden einer Halbleiterschicht eines ersten Leitfähigkeitstyps (11) an einem Substrat (5), wobei die Halbleiterschicht des ersten Leitfähigkeitstyps (11) eine erste Halbleiterschicht (14), eine zweite Halbleiterschicht (16) und eine PEC-Ätzsteuerschicht (15) zwischen der ersten Halbleiterschicht (14) und der zweiten Halbleiterschicht (16) umfasst;
Bilden einer aktiven Schicht (12) an der Halbleiterschicht des ersten Leitfähigkeitstyps (11);
Bilden einer Halbleiterschicht eines zweiten Leitfähigkeitstyps (13) an der aktiven Schicht (12);
Bilden einer reflektierende Elektrode (50) an der Halbleiterschicht des zweiten Leitfähigkeitstyps (13); und
Bilden eines Trägerelements (70) an der reflektierenden Elektrode (50);
Entfernen des Substrats (5); und
Durchführen eines PEC-Ätzens an der exponierten Halbleiterschicht des ersten Leitfähigkeitstyps (11), um eine Rauigkeit (17) an einer oberen Oberfläche der Halbleiterschicht des ersten Leitfähigkeitstyps (11) zu bilden,
**dadurch gekennzeichnet, dass**
die PEC-Ätzsteuerschicht (15) eine AlN-Schicht umfasst und eine aktivierte Dotierkonzentration von Null (0) aufweist, und dass ein Bereich eines Abschnitts der PEC-Ätzsteuerschicht (15) durch die Rauigkeit (17) exponiert ist.

4. Lichtemittierungsvorrichtungsbaugruppe umfassend:
einen Körper;
eine an dem Körper angeordnete Lichtemittierungsvorrichtung nach einem der Ansprüche 1 bis 2; und
eine erste Anschlusselektrode und eine zweite Anschlusselektrode, die mit der Lichtemittierungsvorrichtung elektrisch verbunden sind.

5. Lichteinheit umfassend:
eine Platte;
eine an der Platte angeordnete Lichtemittierungsvorrichtung nach einem der Ansprüche 1 bis 2; und
ein optisches Element, das von der Lichtemittierungsvorrichtung bereitgestelltes Licht passieren lässt.

## Revendications

1. Un dispositif émetteur de lumière comprenant :
une couche semi-conductrice (11) d'un premier type de conductivité fournissant une rugosité (17) sur une surface supérieure d'elle-même et comprenant une couche de commande obtenue par gravure photoélectrochimique (PEC) (15) ;
une couche active (12) sous la couche semi-conductrice (11) du premier type de conductivité ;
une couche semi-conductrice (13) d'un deuxième type conductivité, sous la couche active (12) ;
une électrode réfléchissante (50) reliée électriquement à la couche semi-conductrice (13) du deuxième type conductivité ; et
une première électrode (20) reliée électriquement à la couche semi-conductrice (11) du premier type de conductivité,
la couche semi-conductrice (11) du premier type de conductivité comprenant une première couche semi-conductrice (14) et une deuxième couche semi-conductrice (16), ladite couche (15) de commande obtenue par gravure PEC étant disposée entre la première couche semi-conductrice (14) et la deuxième couche semi-conductrice (16), ladite rugosité (17) étant appliquée à une surface supérieure de ladite première couche semi-conductrice (14) ;
**caractérisé en ce que** la couche de commande (15) obtenue par gravure PEC comprend une couche en AlN et a une concentration de dopage activée de zéro (0) ;
et **en ce qu'**une surface d'une partie de la couche de commande (15) obtenue par gravure PEC est exposée par la rugosité (17)

2. Le dispositif émetteur de lumière selon la revendication 1, comprenant en outre une couche de contact ohmique (40) disposée entre l'électrode réfléchissante (50) et la couche semi-conductrice (13) du deuxième type conductivité.

3. Un procédé de fabrication d'un dispositif émetteur de lumière comprenant :
le fait de former une couche semi-conductrice (11) d'un premier type de conductivité sur un substrat (5), ladite couche semi-conductrice (11) du premier type de conductivité comprenant une première couche semi-conductrice (14), une deuxième couche semi-conductrice (16) et une couche de commande (15) obtenue par gravure PEC située entre la première couche semi-conductrice (14) et la deuxième couche semi-conductrice (16) ;
le fait de former une couche active (12) sur la couche semi-conductrice (11) du premier type de conductivité ;
le fait de former une couche semi-conductrice (13) du deuxième type conductivité sur la couche active (12) ;
le fait de former une électrode réfléchissante (50) sur la couche semi-conductrice (13) du deuxième type conductivité ;
le fait de former un élément de support (70) sur l'électrode réfléchissante (50) ;
le fait d'enlever le substrat (5) ; et
le fait d'effectuer une gravure PEC sur la couche semi-conductrice (13) du premier type de conductivité exposée pour former une rugosité (17) sur une surface supérieure de la couche semi-conductrice (11) du premier type de conductivité, **caractérisé en ce que**
la couche de commande (15) obtenue par gravure PEC comprend une couche en AlN et a une concentration en dopage activé de zéro (0), et **en ce qu'**une surface d'une partie de ladite couche de commande (15) obtenue par gravure PEC est exposée par la rugosité (17).

4. Un boîtier de dispositif émetteur de lumière comprenant :
un corps ;
un dispositif émetteur de lumière disposé sur le corps et selon l'une quelconque des revendications 1 à 2 ; et
une première électrode conductrice et une deuxième électrode conductrice reliées électriquement au dispositif émetteur de lumière.

5. Une unité d'éclairage comprenant :
une carte ;
un dispositif émetteur de lumière disposé sur la carte et selon l'une quelconque des revendications 1 à 2 ; et
un élément optique laissant passer la lumière fournie par le dispositif émetteur de lumière.
